# EUROPÄISCHE PATENTANMELDUNG

(11) **EP 1 246 228 A1**
(43) Veröffentlichungstag der Anmeldung: **02.10.2002**
(21) Anmeldenummer: 01108331.8
(22) Anmeldetag: 03.04.2001
(51) Int. Cl.: H01L 21/00, B28D 5/00

(54) **Verfahren und Vorrichtung zum Ablösen eines Halbleiterwafers von einem Träger**

(30) Priorität: 21.02.2001 DE 10108369
(71) Anmelder: B.L.E. Laboratory Equipment GmbH, 78315 Radolfzell (DE)
(72) Erfinder: Muffler, Pirmin Gerhard, 78359 Orsingen-Nenzingen (DE)
(74) Vertreter: Jeck, Anton, Dipl.-Ing.

(57) **Zusammenfassung**

Die Erfindung betrifft ein Verfahren und Vorrichtungen zum Ablösen eines Halbleiterwafers von einem Träger. Dieser Träger ist mittels eines Klebers aufgebracht. Der Rand des Halbleiterwafers wird zunächst mit dem Randlösemittel angelöst. Der Halbleiterwafer wird mit einer auf seine obere Fläche wirkenden Saugvorrichtung abgelöst.

## Beschreibung

Die Erfindung betrifft ein Verfahren und Vorrichtungen zum Ablösen eines Halbleiterwafers von einem Träger gemäß dem Oberbegriff der Ansprüche 1, 4 und 6.

Ein derartiges Verfahren ist aus dem Prospektblatt der Firma Daitron in Oregon, USA, vom 11.1.2001 unter dem Titel "Daitron, Flexible Innovation" bekannt, bei dem zur Ablösung des Halbleiterwafers vom Träger DI-Wasser verwendet wird.

Es ist auch allgemein bekannt, die Halbleiterwafer von den Trägern durch chemische Mittel, die vom Waferrand her und von in den Träger gebohrten Löchern her am Halbleiterwafer angreifen, abzulösen.

Mit diesen bekannten Verfahren wird die eine Struktur aufweisende, untere Fläche des Halbleiterwafers zwar schonend abgelöst, doch beansprucht die Ablösung sehr viel Zeit.

Die Aufgabe der Erfindung besteht daher darin, ein Verfahren und eine Vorrichtung der in den Ansprüchen 1, 4 und 6 genannten Art zu schaffen, mit denen bei schonender Ablösung die Ablösezeit verkürzt werden kann.

Diese Aufgabe wird mit den Merkmalen des Anspruchs 1 einerseits und den Merkmalen der Ansprüche 4 und 6 andererseits gelöst.

Durch die kombinierte Wirkung der Randlösemittel und der Saugvorrichtung lässt sich der Halbleiterwafer sehr rasch ablösen. Meistens genügt es bereits, insbesondere wenn als Kleber Wachs verwendet wird, mit dem Randlösemittel einen schmalen Waferrandbereich anzulösen, um den restlichen Waferbereich vom Träger blitzartig zu trennen.

Weitere zweckmäßige und vorteilhafte Maßnahmen der Erfindung gehen aus den Unteransprüchen hervor.

Gemäß einer weiteren Ausbildung des Verfahrens rotieren Saugvorrichtung und Träger in gleicher Weise. Dadurch kann das Verfahren einfacher als bei einem Verfahren, das mit umlaufendem Randlösemittel arbeitet, gestaltet werden.

Gemäß einer weiteren Ausbildung des Verfahrens arbeitet die Saugvorrichtung mit einem Saugstrom oszillierender Stärke. Infolge des oszillierenden Saugstroms wird die Ablösung beschleunigt.

Die Vorrichtung zur Durchführung des Verfahrens kann gemäß einer weiteren Ausbildung der Erfindung zweckmäßig derart gestaltet sein, dass das Randlösemittel durch ein zwischen Halbleiterwafer und Träger angreifendes, einschneidendes Messer gebildet ist. Dabei ist das Messer vorzugsweise scheibenförmig ausgebildet, um Platz zu sparen.

Die Vorrichtung zur Durchführung des Verfahrens kann aber alternativ auch gemäß einer weiteren Ausbildung der Erfindung zweckmäßig derart gestaltet sein, dass das Randlösemittel durch einen tangential zwischen Halbleiterwafer und Träger angreifenden Fluidstrahl gebildet ist. Der Fluidstrahl kann ein Luftoder Flüssigkeitsstrahl sein.

Gemäß einer weiteren Ausbildung der Erfindung ist die Saugvorrichtung löcherähnlich mit einer Absaugöffnung aufweisenden, konkaven, unteren Fläche ausgebildet, die eine Abrollbewegung auf dem Wafer ausführt.

Gemäß einer weiteren, alternativen Ausbildung der Erfindung ist die Saugvorrichtung mit einer Absaugöffnung aufweisenden, ebenen, unteren Fläche ausgebildet, die eine Hubbewegung ausführt. Diese Ausbildung hat gegenüber der vorhergehenden Ausbildung die Vorteile, dass keine Abrollbewegungen ausgeführt werden müssen und die Reinigung der Halbleiterwafer von unten einfacher ist.

Gemäß einer weiteren Ausbildung der Erfindung ist der Halbleiterwaferrand auf der Seite des Trägers angefast. Da der angefaste Bereich für die auf der Waferunterseite aufgebrachten Struktur sowieso nicht benutzt wird, kann dadurch das Randlösemittel besser angreifen.

Die Erfindung wird nun anhand von Ausführungsbeispielen näher erläutert. Es zeigen:
- Fig. 1: eine Seitenansicht eines Trägers und einer darauf aufgeklebten Halbleiterwafer,
- Fig. 2: eine verkleinerte Draufsicht auf die Anordnung der Fig. 1 und ein das Randlösemittel darstellendes Messer,
- Fig. 3: eine verkleinerte Draufsicht auf die Anordnung der Fig. 1 und einen das Randlösemittel darstellenden Fluidstrahl,
- Fig. 4: eine vergrößerte Seitenansicht eines Waferrandabschnitts,
- Fig. 5: eine Seitenansicht der in Fig. 1 dargestellte Anordnung und einer Saugvorrichtung erster Art,
- Fig. 6: eine Seitenansicht der in Fig.1 dargestellten Anordnung und einer Saugvorrichtung zweiter Art und
- Fig. 7: eine perspektivische Darstellung der in Fig. 6 dargestellten Anordnung.

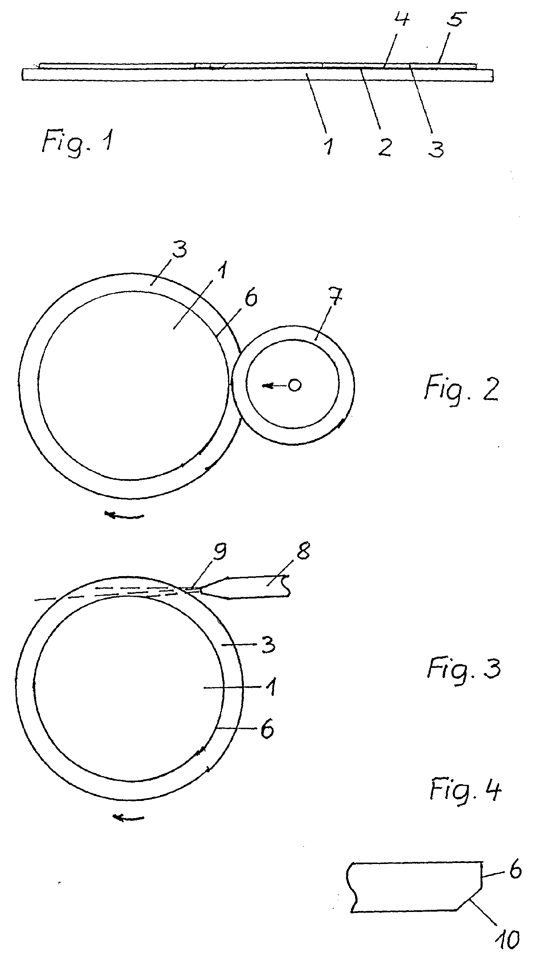

Ein in Fig. 1 dargestelter, runder Halbleiterwafer 1 (im Folgenden kurz "Wafer" genannt) ist mittels eines Klebers 2, vorzugsweise eines Wachses, auf einem runden Träger 3, beispielsweise einer Glasplatte, aufgebracht. Der Wafer 1 weist auf seiner unteren Fläche 4 eine Struktur auf, die beispielsweise eine integrierte Schaltung ist. Die obere Fläche 5 des Wafers 1 kann einem Schleifvorgang und/oder Poliervorgang unterworfen worden sein, und danach soll der Wafer 1 vom Träger 3 abgelöst werden.

Zu diesem Zweck kann in einem ersten Verfahrensschritt so verfahren werden, wie es in Fig. 2 angedeutet ist. Zwischen dem Waferrand 6 und dem Träger 3 greift ein Randlösemittel in Form eines drehbar angeordneten, scheibenförmigen Messers 7 ein. Dabei werden Träger 3 und Wafer 1 in Drehung (s. Pfeil) versetzt, während das Messer 7 in Richtung auf den Wafermittelpunkt langsam bewegt wird, so dass der Waferrand 6 abgelöst wird.

Für den ersten Verfahrensschritt kann aber auch eine Anordnung nach Fig. 3 verwendet werden. Dort lenkt ein Randlösemittel in Form einer Düse 8 und eines Fluidstrahls 9, der ein Luftstrahl oder ein Flüssigkeitsstrahl sein kann, diesen Fluidstrahl mit hoher Geschwindigkeit tangential auf den Waferrand 6 unter Drehung (s. Pfeil) des Trägers 3 und des Wafers 1 derart, dass der Waferrand 6 abgelöst wird.

Zur besseren Anlösung des Waferrands 6 kann dieser auf der Seite des Trägers 3 angefast sein, wie durch die Fase 10 in Fig. 4 gezeigt ist.

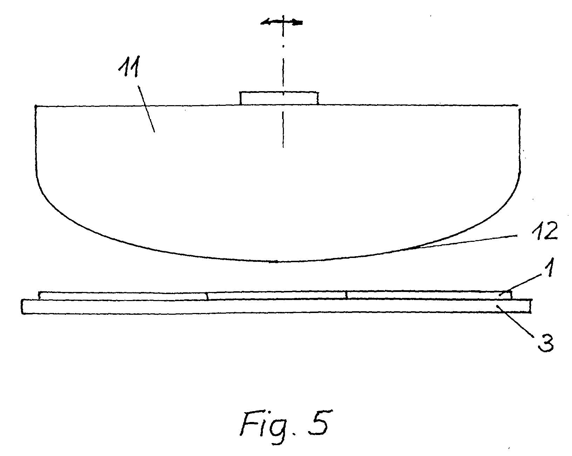

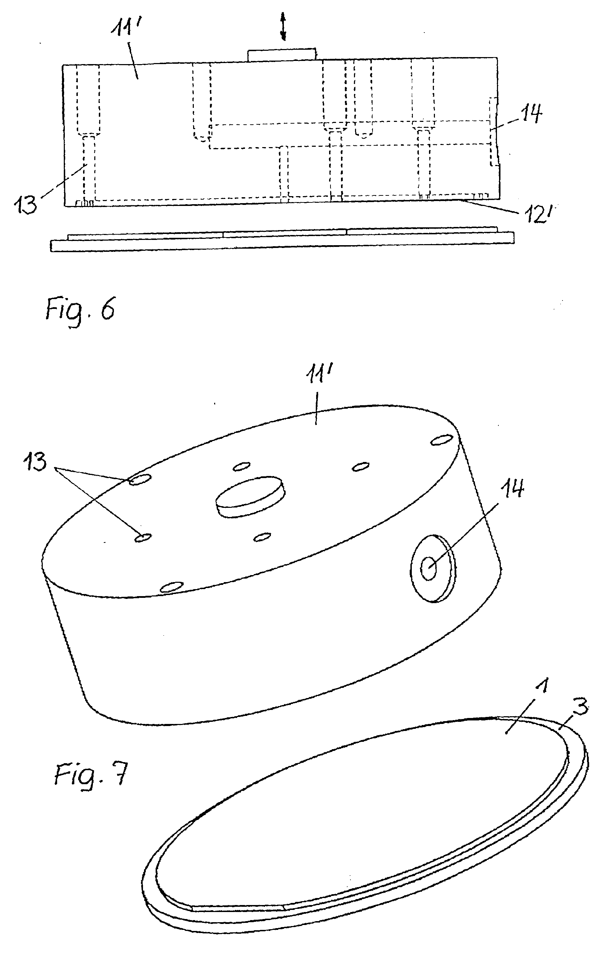

Um den Wafer 1 vom Träger 3 vollends abzulösen, kann eine Saugvorrichtung 11 erster Art nach Fig. 5 in einem zweiten Verfahrensschritt verwendet werden. Diese Saugvorrichtung 11 ist löcherähnlich mit einer Saugöffnungen aufweisenden, konkaven, unteren Fläche 12 ausgebildet ist, die eine Abrollbewegung (S.Doppelpfeil) auf dem Wafer 1 ausführt. Da sich der Träger 3 und der Wafer 1 drehen, muss sich in gleicher Weise auch die Saugvorrichtung 11 mitdrehen. Die Saugöffnungen sind nicht dargestellt, aber in ähnlicher Weise wie in Fig. 6 ausgebildet.

Um den Wafer 1 vom Träger 3 vollends abzulösen, kann alternativ eine Saugvorrichtung 11' zweiter Art nach den Figuren 6 und 7 in einem zweiten Verfahrensschritt verwendet werden. Diese Saugvorrichtung 11' ist in Form eines Vollzylinders ausgebildet und weist eine mit Saugöffnungen, wie den Saugöffnungen 13, versehene, ebene, untere Fläche 12' auf. An die oberen Enden der Saugöffnungen 13, (s. insbesondere Fig. 8) sind in nicht dargestellter Weise zu einer Unterdruckquelle führende Unterdruckschläuche angeschlossen. Die Saugvorrichtung 11' wird zur Ablösung des Wafers 1 vom Träger in senkrechter Richtung (s.Doppelpfeil) bewegt und führt damit eine Hubbewegung aus. Die Saugvorrichtung 11' ist ferner mit einem Belüftungskanal 14 versehen. Wie in Fig. 6 angedeutet ist, wird der Wafer 1 zunächst mittels im Randbereich der Fläche 12' angeordneter Ringöffnungen in einem Waferrandbereich und dann zum Waferzentrum fortlaufend vom Träger 3 abgelöst.

Beide Saugvorrichtungen 11, 11' können mit einem Saugstrom oszillierender Stärke arbeiten, so dass die Ablösung einfacher und schneller erfolgt.

Der mit dem Randlösemittel 7 bzw. 8, 9 bereits angelöste Wafer 1 wird somit durch die Absaugvorrichtung 11 bzw. 11' vollends sehr schnell abgezogen. Es ist auch möglich, die Randlösemittel 7 bzw. 9 weiter zum Waferzentrum hin nachzuführen.

## Patentansprüche

1. Verfahren zur Ablösung eines Halbleiterwafers von einem Träger, auf dem der Halbleiterwafer mittels eines Klebers fixiert ist,
**dadurch gekennzeichnet,**
**dass** der Rand (6) des Halbleiterwafers (1) zunächst mit einem Randlösemittel (7; 8, 9) angelöst wird und dass dann der Halbleiterwafer (1) mit einer auf seine obere Fläche (5) wirkenden Saugvorrichtung (11, 11') weiter abgelöst wird.

2. Verfahren nach Anspruch 1,
**dadurch gekennzeichnet,**
**dass** Saugvorrichtung (11, 11') und Träger (3) in gleicher Weise rotieren.

3. Verfahren nach Anspruch 1 oder 2,
**dadurch gekennzeichnet,**
**dass** die Saugvorrichtung (11, 11') mit einem Saugstrom oszillierender Stärke arbeitet.

4. Vorrichtung zur Durchführung des Verfahrens nach einem der Ansprüche 1 bis 3,
**dadurch gekennzeichnet,**
**dass** das Randlösemittel durch ein zwischen Halbleiterwafer (1) und Träger (3) angreifenden, einschneidendes Messer (7) gebildet ist.

5. Vorrichtung nach Anspruch 4,
dass das Messer (7) scheibenförmig ausgebildet ist.

6. Vorrichtung zur Durchführung des Verfahrens nach einem der Ansprüche 1 bis 3,
**dadurch gekennzeichnet,**
**dass** das Randlösemittel durch einen tangential zwischen Halbleiterwafer (1) und Träger (3) angreifenden Fluidstrahl (9) gebildet ist.

7. Vorrichtung nach einem der Ansprüche 4 bis 6,
**dadurch gekennzeichnet,**
**dass** die Saugvorrichtung löcherähnlich mit einer Saugöffnungen aufweisenden, konkaven, unteren Fläche (12) ausgebildet ist, die eine Abrollbewegung auf dem Wafer (1) ausführt.

8. Vorrichtung nach einem der Ansprüche 4 bis 6,
**dadurch gekennzeichnet,**
**dass** die Saugvorrichtung mit einer Saugöffnung (13) aufweisenden, ebenen, unteren Fläche (12') ausgebildet ist, die eine Hubbewegung ausführt.

9. Vorrichtung nach einem der Ansprüche 4 bis 8,
**dadurch gekennzeichnet,**
**dass** der Halbleiterwaferrand (6) auf der Seite des Trägers (3) angefast ist (10).
